Europäisches Patentamt

European Patent Office

Office européen des brevets

(11) Numéro de publication: **0 230 838**
**A2**

(12) **DEMANDE DE BREVET EUROPEEN**

(21) Numéro de dépôt: **86402963.2**

(22) Date de dépôt: **30.12.86**

(51) Int. Cl.4: **H03K 7/08 , H03K 9/08 ,**
**H03M 1/36 , H03M 1/82 ,**
**H04B 14/02**

(30) Priorité: **13.01.86 FR 8600357**

(43) Date de publication de la demande:
**05.08.87 Bulletin 87/32**

(84) Etats contractants désignés:
**BE CH DE GB LI NL**

(71) Demandeur: **Kalfon, René**
**816, rue de la Haie**
**F-76230 Bois Guillaume(FR)**

(72) Inventeur: **Kalfon, René**
**816, rue de la Haie**
**F-76230 Bois Guillaume(FR)**

(74) Mandataire: **Martinet & Lapoux**
**62, rue des Mathurins**
**F-75008 Paris(FR)**

(54) Modulateur et démodulateur d'impulsions modulées en durée.

(57) Les modulateur et démodulateur dans une liaison de transmission sont complètement asynchrones. Le modulateur comprend un circuit de quantification (qua, QUA) pour produire des mots de quantification représentant des valeurs quantifiées d'échantillons d'un signal entrant, un circuit d'échantillonnage (2) pour produire des impulsions ayant une largeur prédéterminée modulées en position respectivement en fonction de mots de quantification prélevés à une période d'échantillonnage, et un circuit de modulation (3) pour convertir les impulsions modulées en position en des impulsions modulées en durée ($IM1_{ij}$). Pendant une période d'échantillonnage, le démodulateur détecte le front avant d'une impulsion modulée en durée et charge un condensateur par l'impulsion détectée pendant une durée au moins égale à une largeur maximale des impulsions reçues pour délivrer un échantillon de tension ($e_{ij}$) proportionnelle à la durée de l'impulsion.

FIG.1B

## Modulateur et démodulateur d'impulsions modulées en durée

La présente invention concerne un modulateur à une extrémité d'une liaison de transmission pour moduler des impulsions en durée en fonction d'un signal entrant analogique ou numérique, ainsi qu'un démodulateur à une autre extrémité de la liaison pour démoduler les impulsions modulées en durée transmises par le modulateur en des échantillons du signal entrant qui sont ensuite lissés pour restituer le signal entrant.

L'invention vise principalement à fournir de tels modulateur et démodulateur qui sont complètement asynchrones, c'est-à-dire possédant des bases de temps complètement indépendantes. En particulier, tant dans le modulateur que dans le démodulateur, une période d'échantillonnage du signal entrant et une fréquence porteuse des impulsions sont fixées par des bases de temps respectives indépendantes si bien que dans le démodulateur, différents signaux d'horloge nécessaires au fonctionnement du démodulateur sont établis, non pas au moyen d'une quelconque récupération de rythme à partir des impulsions reçues, mais à partir d'une fréquence d'horloge de base produite localement.

Ainsi, en programmant des fréquences d'horloge, il est possible de modifier dans une large gamme aussi bien la période d'échantillonnage que la durée maximale des impulsions modulées en durée et leur fréquence porteuse. Ceci permet de remplacer les liaisons de communication traditionnelles du type MIC par des liaisons dans lesquelles chacun des canaux multiplexés temporellement est caractérisé par une période d'échantillonnage éventuellement différente de celles des autres canaux et une fréquence porteuse différente de celles des autres canaux. Les fréquences porteuses peuvent être différentes de quelques hertz, compte tenu de performances de dispositifs de détection d'impulsions en fonction de leur durée ou de porteuses en fonction de leur fréquence inclus dans le démodulateur, et n'occasionnent pas ainsi un élargissement sensible de la bande passante des moyens de transmission actuellement utilisés pour des signaux MIO.

Selon l'invention, un modulateur est tel que défini dans la revendication 1.

Selon une réalisation préférée, reprenant par exemple une loi de quantification connue à I.J = 16.16 = 256 valeurs quantifiées utilisées pour un signal MIC, les mots de quantification représentent des valeurs quantifiées d'échantillons selon une loi de quantification à I.J valeurs quantifiées, et chaque mot de quantification est composé d'une première partie comprenant I bits parmi lesquels seulement un bit a un état logique prédéterminé et a un rang dans ladite première partie indiquant une première valeur quantifiée de l'échantillon parmi I valeurs quantifiées, et d'une seconde partie comprenant J bits parmi lesquels seulement un bit a l'état prédéterminé et a un rang dans ladite seconde partie indiquant une seconde valeur quantifiée de l'échantillon parmi J valeurs quantifiées au voisinage de ladite première valeur quantifiée de l'échantillon ; les moyens d'échantillonnage produisent une impulsion ayant une position dans chaque période d'échantillonnage qui est une fonction linéaire du rang dudit bit dans la première partie du mot prélevé et du rang dudit bit dans la seconde partie du mot prélevé.

Lorsque le signal entrant est un signal analogique, les moyens d'entrée sont un circuit de quantification quantifiant continûment la tension instantanée du signal entrant. Ce circuit de quantification est du genre de celui décrit dans la demande de brevet français 86-00305 déposée le 10 Janvier 1986.

Lorsque le signal entrant est un signal numérique du type MIC, les moyens d'entrée sont des moyens de transcodage convertissant chaque octet du signal MIC en un mot de quantification à chaque période d'échantillonnage.

Selon l'invention, un démodulateur est tel que défini dans la revendication 11.

Selon une caractéristique du démodulateur, les moyens pour charger et délivrer comprennent des moyens de comptage recevant des impulsions d'horloge asynchrones de quelconques impulsions d'horloge dans le modulateur, déclenchés par le front avant détecté de chaque première impulsion modulée en position et remis à zéro après une période d'échantillonnage succédant à la détection du front avant, pour établir les première et seconde durées.

Afin de sécuriser la transmission entre modulateur et démodulateur et permettre d'éliminer le signal entrant à la réception, ou provoque une répétition de message dans le cas de liaisons télématiques, lorsque les impulsions transmises sont perturbées, des première et seconde impulsions modulées en position et complémentaires par paire dans une période d'échantillonnage sont transmises par le modulateur. Dans ce cas, les premières impulsions modulées en position ont des largeurs inférieures à une première durée inférieure à la période d'échantillonnage et le modulateur comprend des moyens pour produire une second impulsion modulée en durée ayant une durée complémentaire de la durée de la première impulsion dans la première durée de chaque période d'échantillonnage ; le démodulateur comprend alors des moyens pour vérifier la complémentarité des durées de première et seconde impulsions dans la première durée afin de délivrer l'une des première et seconde impulsions aux moyens pour détecter le front montant et aux moyens pour charger et délivrer lorsque la complémentarité est vérifiée. Selon d'autres caractéristiques du démodulateur, celui-ci peut comprendre des moyens pour inhiber la délivrance de l'une de première et seconde impulsions modulées en position pendant une période d'échantillonnage aux moyens pour détecter le front montant et aux moyens pour charger et délivrer lorsque la complémentarité des durées de première et seconde impulsions reçues n'est pas vérifiée, et des moyens pour délivrer l'une de première et seconde impulsions modulées en position pendant une période d'échantillonnage aux moyens pour détecter le front montant et aux moyens pour charger et délivrer lorsque l'autre des première et seconde impulsions n'est pas reçue ou lorsqu'une fréquence porteuse modulée par l'autre des première et seconde impulsions dans le modulateur n'est pas détectée dans le démodulateur. Grâce à ces derniers moyens inclus dans le démodulateur, l'ensemble modulateur et démodulateur selon l'invention offre une action anti-parasite et anti-fading qui, ajoutée à l'avantage d'une bande passante très étroite, confère à l'ensemble une très haute qualité et sécurité de transmission, notamment en émissions radio.

D'autres avantages et caractéristiques de l'invention apparaîtront plus clairement à la lecture de la description suivante de plusieurs réalisations de l'invention en référence aux dessins annexés correspondants dans lesquels :

-les Figs.1A et 1B sont un bloc-diagramme - schématique d'un modulateur d'impulsions en durée selon l'invention, comprenant un circuit de quantification montré en détail ;

-la Fig.2 est un bloc-diagramme d'un démodulateur selon l'invention :

-la Fig.3 montre en détail un circuit d'échantillonnage, un circuit de modulation et une base de temps inclus dans le modulateur ;

-la Fig.4 sont des diagrammes temporels de signaux et impulsions établis dans le modulateur et le démodulateur respectivement ;

-la Fig.5 montre en détail un circuit de détection et de validation d'impulsion reçue, inclus dans le démodulateur ; et

-la Fig.6 montre un circuit de démodulation inclus dans le démodulateur.

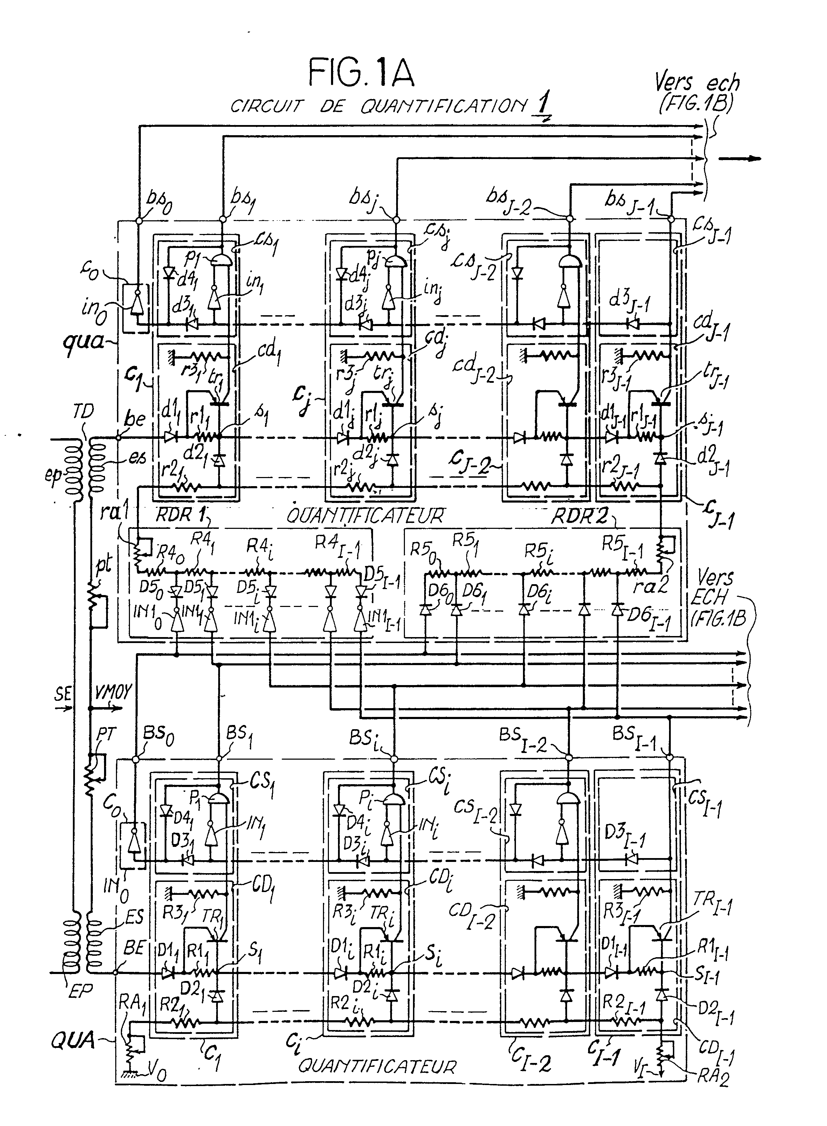

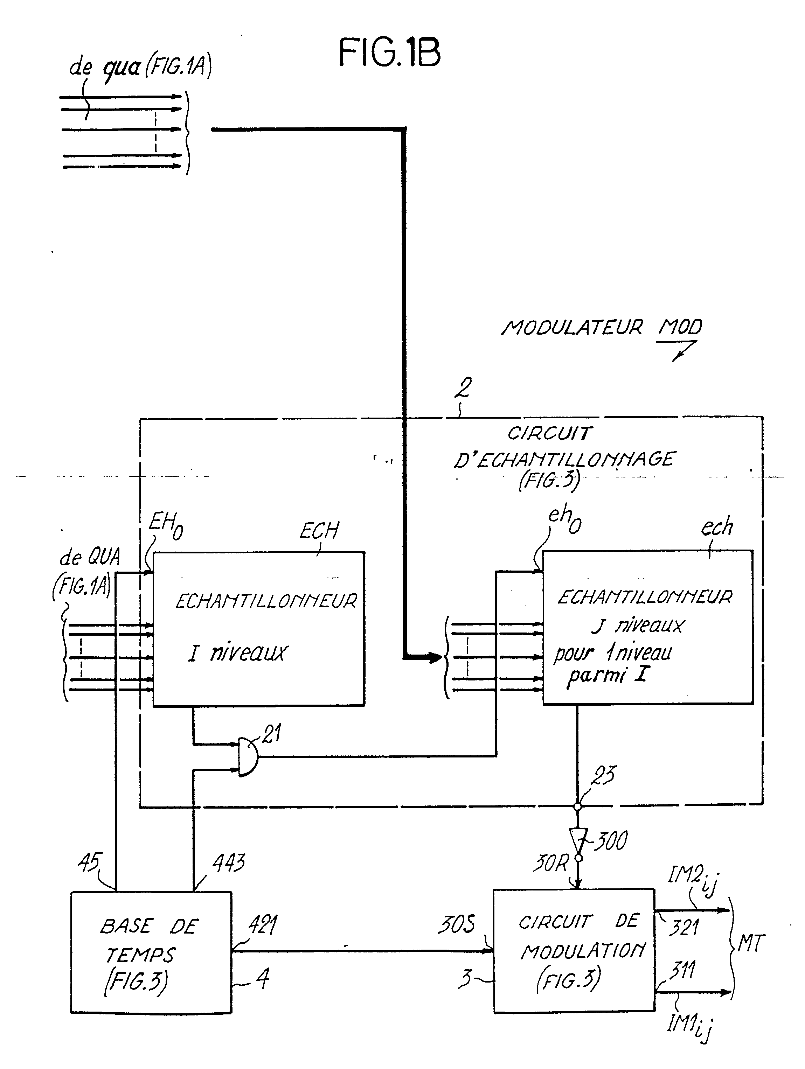

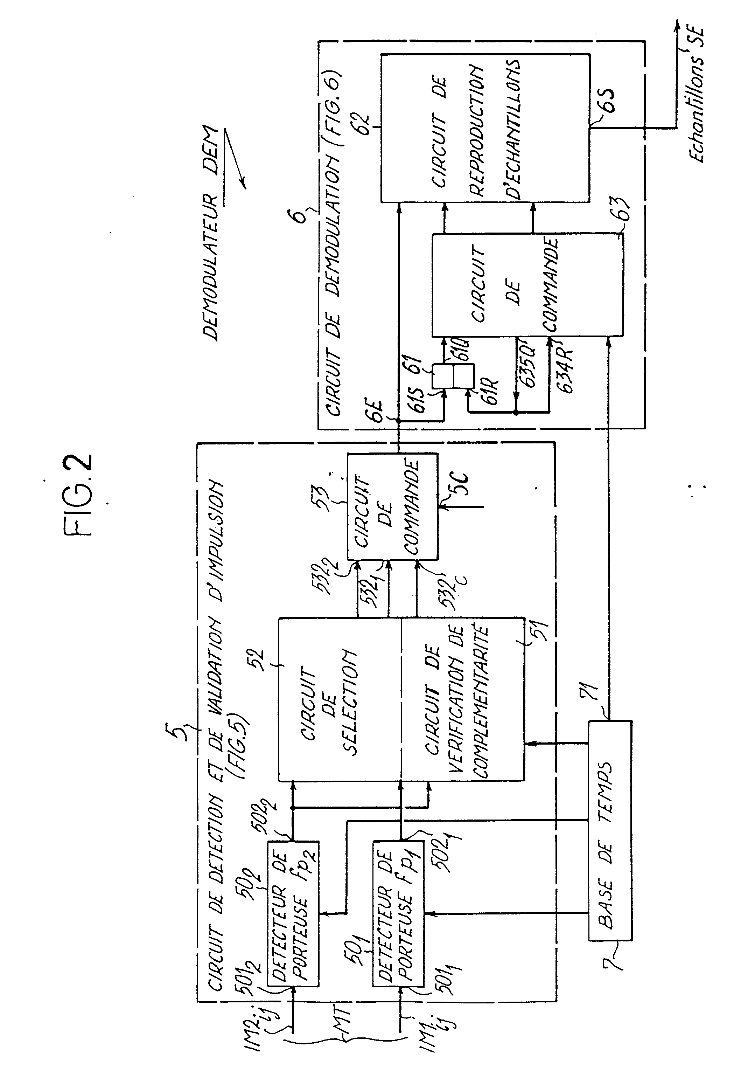

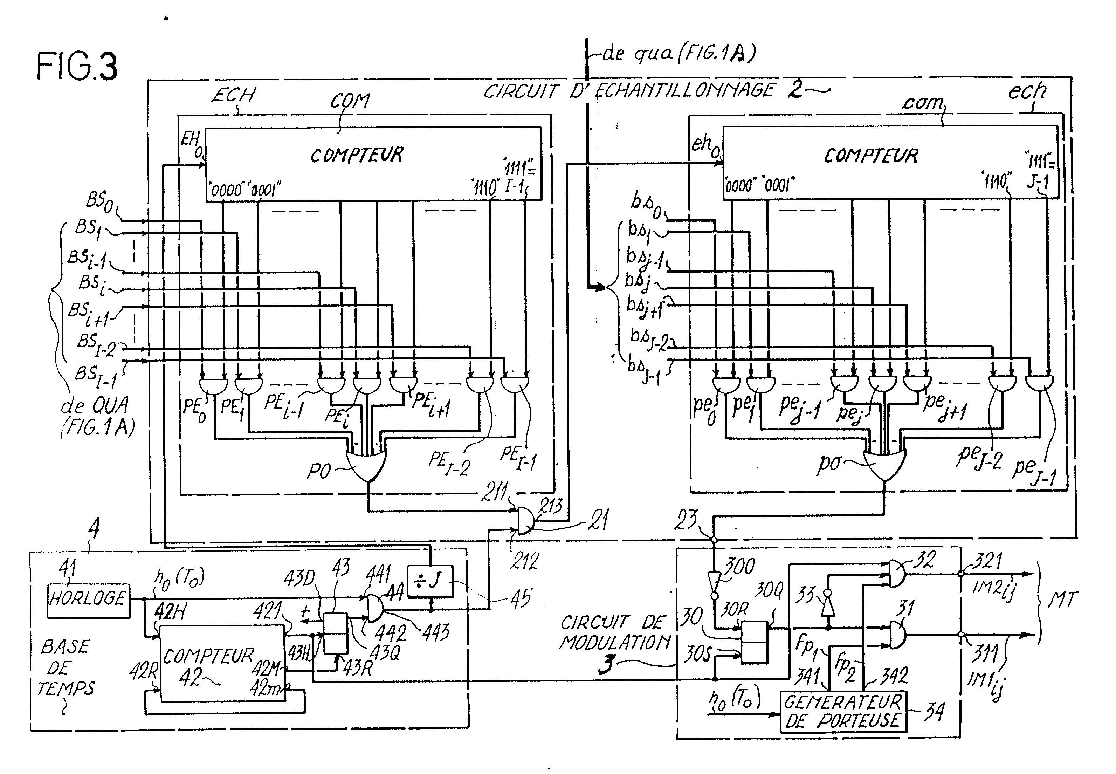

Dans les Figs.1A et 1B est représenté - schématiquement un modulateur d'impulsions en durée MOD qui selon une première réalisation, est destiné à quantifier et échantillonner un signal modulant entrant analogique SE et à convertir des mots représentant des valeurs quantifiées du signal en des durées d'impulsion. Le signal modulant entrant est, d'une manière générale, un signal analogique qui peut être un signal de modulation en amplitude, en fréquence ou en phase, tel que par exemple un signal à basse fréquence du genre signal téléphonique. Le modulateur MOD comprend un circuit de quantification 1 pour quantifier instantanément le signal entrant de tension dans I.J intervalles de quantification, un circuit d'échantillonnage 2 pour prélever pendant une période d'échantillonnage $T_e$ un mot de quantification transmis par le circuit 2 et représentatif d'une valeur quantifiée du signal entrant, un circuit de modulation 3 pour convertir chaque valeur quantifiée en une durée d'impulsion modulant une porteuse, et une base de temps 4 commandant les circuits 2 et 3. Dans la Fig.2 est représenté un démodulateur DEM selon l'invention recevant des impulsions de différentes durées transmises par le circuit de modulation 3 à travers un moyen de transmission MT, par exemple tel que ligne téléphonique dans un réseau commuté téléphonique. Le démodulateur DEM comprend un circuit de détection et de validation 5 pour supprimer la porteuse, détecter les impulsions reçues et, de préférence, pour valider leur durée, un circuit de démodulation 6 pour convertir chaque impulsion détectée en un échantillon de tension dépendant de la durée de l'impulsion détectée, et une base de temps 7.

Comme montré en détail à la Fig.1A, le circuit de quantification 1 est un circuit de quantification acyclique à vitesse de fonctionnement élevé tel celui décrit dans la demande de brevet français 86-00305 déposée le 10 janvier 1986 au nom de l'actuel demandeur. Le circuit 1 est partagé en deux quantificateurs QUA et qua par un transformateur différentiel d'entrée TD. Le signal entrant SE à quantifier est appliqué à un double enroulement primaire EP + ep du transformateur TD et est reproduit et polarisé positivement aux bornes de deux demi-enroulements secondaires ES et es du transformateur. Chacun des demi-enroulements secondaires ES, es a une borne portée à travers un potentiomètre PT, pt à une tension positive convenable VMOY correspondant une valeur moyenne de l'amplitude crête-à-crête du signal entrant. Les autres bornes des demi-enroulements ES et es constituent des bornes d'entrée BE, be des quantificateurs QUA et qua respectivement.

Le quantificateur QUA est destiné à quantifier le signal entrant dans une plage de quantification $VT_o$ à $VT_I$ partagée en I = 16 premiers intervalles de quantification de tension consécutifs $VT_o, VT_1$ à $VT_{I-1}, VT_I$ respectivement associée à I premières cellules de quantification $C_o$ à $C_{I-1} = C_{15}$ Toutes les cellules sont identiques à l'exception de la première $C_o$ et de la dernière $C_{I-1}$. Chacune des

cellules $C_i$ de rangs i compris entre 1 et I-2 contient un circuit de détection $CD_i$ pour détecter une tension entrante supérieure à un niveau de décision définie par une tension limite inférieure $VT_i$ et comprise dans l'intervalle de quantification respectif $VT_i$ à $VT_{i+1}$, et un circuit de signalisation $CS_i$ pour signaler par un état logique "1" à une borne de sortie $BS_i$ de la cellule une tension entrante comprise dans cet intervalle de quantification. La première cellule $C_0$ ne comprend qu'un circuit de signalisation $CS_0$ constitué par un simple inverseur $IN_0$, et la dernière cellule $C_{I-1}$ contient un circuit de détection $CD_{I-1}$ analogue à ceux $CD_1$ à $CD_{I-2}$ dans les cellules $C_1$ à $C_{I-2}$, et un circuit de signalisation $CS_{I-1}$ ne comprenant qu'une diode D3 $_{I-1}$.

Dans la cellule $C_i$ représentée en détail à la Fig.1A, le circuit de détection $CD_i$ comprend une résistance $R2_i$ reliée en série avec d'autres telles résistances dans les cellules $C_1$ à $C_{I-1}$ entre des bornes à la masse et à une tension positive d'une source d'alimentation qui détermine la plage de quantification $VT_0 = 0$ à $VT_I$ du circuit de quantification 1. Les bornes des résistances $R2_1$ et $R2_{I-1}$ sont ainsi portées aux limites de tension $VT_0$ à $VT_I$ des intervalles de quantification. Par exemple dans la cellule $C_i$, une borne $T_i$ de la résistance $R2_i$ reliée à la résistance $R2_{i+1}$ dans la cellule de rang i+1 est portée à la tension $VT_i$, laquelle est reportée à travers une diode $D2_i$ à une borne $S_i$ d'un réseau de résistances et diodes en série. Ce dernier réseau comprend entre la borne d'entrée BE et l'anode de la diode D2 $_{I-1}$ dans la cellule $C_{I-1}$, des ensembles de diode et résisttance en série $D1_1$, $R1_1$ à $D1_{I-1}$, $R1_{I-1}$ ; dans une cellule $C_i$, la résistance $R1_i$ est connectée entre des émetteur et base d'un transistor bipolaire PNP $TR_i$. Ainsi pour une tension à la borne BE, par exemple comprise sensiblement entre $VT_i$ et $VT_{i+1}$, les diodes $D1_1$ à $D1_i$ sont passantes et les transistors $TR_1$ à $TR_i$ sont activés, ou en d'autres termes, le transistor $TR_i$ est activé pour une tension à la borne BE excèdant la tension limite inférieure $VT_i$ de l'intervalle $(VT_i, VT_{i+1})$ associé à la cellule $C_i$, grâce à la division de tension créée par le réseau de résistances $R2_1$ à $R2_{I-1}$ et le réseau de diodes et résistances $R1_1$ à $R12_{I-1}$ et $D1_1$ à $D1_{I-1}$. Il est à noter qu'en absence de signal entrant, la tension à la borne BE est ajustée à une tension moyenne sensiblement égale à VMOY et comprise dans l'intervalle de quantification $(VT_{I/2-1}, VT_{I/2})$ notamment lorsque la quantification est uniforme. Par ailleurs, les valeurs ohmiques des résistances peuvent être choisies pour réaliser une quantification uniforme, ou une quantification non uniforme déduite par exemple d'une fonction logarithmique connue du genre courbe de compression de niveaux de quantification pour modulations par impulsions codées du type MIC.

Dans le circuit de signalisation $CS_i$, une porte ET $P_i$ a une première entrée reliée au collecteur du transistor $TR_i$ afin de mettre à "1" une borne de sortie $BS_i$ de la cellule $C_i$ uniquement lorsque la tension entrante à la borne BE est comprise entre $VT_i$ et $VT_{i+1}$. Lorsque la tension entrante est inférieure à $VT_i$, le transistor $TR_i$ est bloqué ce qui ferme la porte $P_i$. Lorsque la tension entrante et supérieure à $VT_{i+1}$, la borne de sortie de l'une des cellules $C_{i+1}$ à $C_{I-1}$ est activée à l'état "1" ce qui met à l'état "0" une seconde entrée de la porte $P_i$ à travers une diode de la cellule activée, équivalente à la diode $D4_i$ dans la cellule $C_i$, des diodes en série entre la cellule activée et la cellule $C_i$, telles que la diode $D3_i$ dans la cellule $C_i$, et un inverseur $IN_i$ dans la cellule $C_i$.

Une tension du signal entrant polarisée comprise entre $VT_i$ et $VT_{i+1}$ est signalée par l'état "1" à la borne de sortie $BS_i$ de la cellule $C_i$ et par l'état "0" aux bornes de sortie $BS_0$ à $BS_{i-1}$ et $BS_{i+1}$ à $BS_{I-1}$ des autres cellules du quantificateur QUA.

Le second quantificateur qua affine la quantification du signal entrant dans les premiers intervalles $(VT_0, VT_1)$ à $(VT_{I-1}, VT_I)$ en divisant chacun d'eux en J seconds intervalles de quantification. Le quantificateur qua contient J secondes cellules $c_0$ à $c_{J-1}$ agencées d'une manière analogue aux cellules $C_0$ à $C_{I-1}$. Les cellules $c_0$, $c_1$ à $c_{J-2}$ et $c_{J-1}$ sont respectivement analogues aux cellules $C_0$, $C_1$ à $C_{I-2}$ et $C_{I-1}$. Dans la Fig.1, des composants inclus dans la cellule $c_j$ sont désignés par des repères ayant des lettres minuscules et des chiffres correspondant aux lettres majuscules et chiffres des repères désignant des composants équivalents dans la cellule $C_i$. Les nombres I et J de cellules dans les quantificateurs QUA et qua peuvent être égaux ou différents.

Le quantificateur qua comprend également des premier et second réseaux à diodes et résistances RDR1 et RDR2 pour appliquer sélectivement les tensions limites d'un premier intervalle de quantification lorsque la borne de sortie correspondante du premier quantificateur QUA est à l'état "1". Le premier réseau RDR1 applique à la résistance $r2_1$ de la cellule $c_1$ la tension inférieure du premier intervalle sélectionné à travers un potentiomètre ra1, tandis que le second réseau RDR2 applique à la résistance $r2_{J-1}$ de la cellule $c_{J-1}$ la limite supérieure du premier intervalle sélectionné à travers un potentiomètre ra2. Ceci est réalisé dans le réseau RDR1 grâce à des divisions de tension obtenues par des résistances $R4_{I-1}$ à $R4_0$ reliées en série avec la résistance $r2_1$ et le potentiomètre ra1 et ayant des bornes respectives reliées aux bornes

$BS_{I-1}$ à $BS_0$ à travers des ensembles de diode $D5_{I-1}$ à $D5_0$ et inverseur $INV1_{I-1}$ à $INV_0$, et dans le réseau RDR2, grâce à des divisions de tension obtenues par des résistances $R5_0$ à $R5_{I-1}$ reliées en série avec la résistance $r2_{J-1}$ et le potentiomètre ra2 et ayant des bornes respectives reliées aux bornes $BS_0$ à $BS_{I-1}$ à travers des diodes $D6_0$ à $D6_{I-1}$ polarisées en inverse comparativement aux diodes $D5_0$ à $D5_{I-1}$.

Lorsque la borne $BS_i$ est à l'état "1", l'intervalle $(VT_i, VT_{i+1})$ est partagé en J seconds intervalles consécutifs $(vt_{0,i} = VT_i, vt_{1,i})$, $(vt_{1,i}, vt_{2,i})$ à $(vt_{J-2,i}, vt_{J-1,i})$ et $(vt_{J-1,i}, vt_{J,i} = VT_{i+1})$, les tensions limites $vt_{1,i}$ à $vt_{J-1,i}$ étant appliquées aux bornes $t_1$ à $t_{J-1}$ des résistances $r2_1$ à $r2_{J-1}$ dans les cellules $c_1$ à $c_{J-1}$.

A un instant donné, une quantification de la tension instantanée du signal entrant polarisé est marquée par deux bornes de sortie $BS_i$ et $bs_j$ des quantificateurs QUA et qua à l'état "1" parmi $I.J$ = niveaux de quantification possibles. En d'autres termes, une valeur quantifiée de la tension instantanée du signal entrant est représentée par un mot de quantification à un instant donné composé d'une première partie ayant $I-1$ bits à l'état "0" et un bit à l'état "1" délivrés en parallèle par les sorties $BS_0$ à $BS_{I-1}$ et d'une seconde partie ayant $J-1$ bits à l'état "0" et un bit à l'état "1" délivrés en parallèle par les sorties $bs_0$ à $bs_{J-1}$. Par exemple, afin de fixer les idées, les nombres I et J sont supposés égaux à 16 dans la suite, ce qui correspondant à une quantification du signal entrant dans 256 intervalles de quantification.

En référence à la Fig.3, le circuit d'échantillonnage 2 comprend deux échantillonneurs ECH et ech respectivement associés aux quantificateurs QUA et qua qui analysent périodiquement les états des sorties $BS_0$ à $BS_{I-1}$ et $bs_0$ à $bs_{J-1}$ et ainsi prélèvent des mots de quantification à $I+J$ bits à une fréquence d'échantillonnage $F_e = 1/T_e$ afin de les convertir en des impulsions ayant une largeur prédéterminée $T_0$ et des positions dans les périodes d'échantillonnage fonction des valeurs quantifiées du signal entrant. Le circuit d'échantillonage 2 opère ainsi une modulation d'impulsions en position.

Chaque échantillonneur ECH, ech comporte un compteur COM, com ayant $I=J=16$ étages remis à zéro par bouclage sur lui-même, et I,J portes ET à deux entrées $PE_0$ à $PE_{I-1}$, $pe_0$ à $pe_{J-1}$. Les portes $PE_0$ à $PE_{I-1}$ ont des premières entrées reliées aux bornes de sortie $BS_0$ à $BS_{I-1}$ du premier quantificateur QUA, des secondes entrées reliées aux sorties des I étages du compteur COM, et des sorties reliées à I entrées d'une porte OU PO, respectivement. La porte PO a une sortie reliée à une première entrée 211 d'une porte ET 21 ayant une sortie reliée à une entrée d'horloge $eh_0$ du compteur com. De même, les portes $pe_0$ à $pe_{J-1}$ ont des premières entrées reliées aux bornes de sortie $bs_0$ à $bs_{J-1}$ du second quantificateur qua, des secondes entrées reliées aux sorties des J étages du compteur com, et des sorties reliées à J entrées d'une porte OU po, respectivement.

Comme montré également à la Fig.3, la base de temps 4 comprend une horloge 41, un compteur 42 de préférence programmable, une bascule du type D 43, une porte ET à deux entrées 44 et un diviseur de fréquence par J 45.

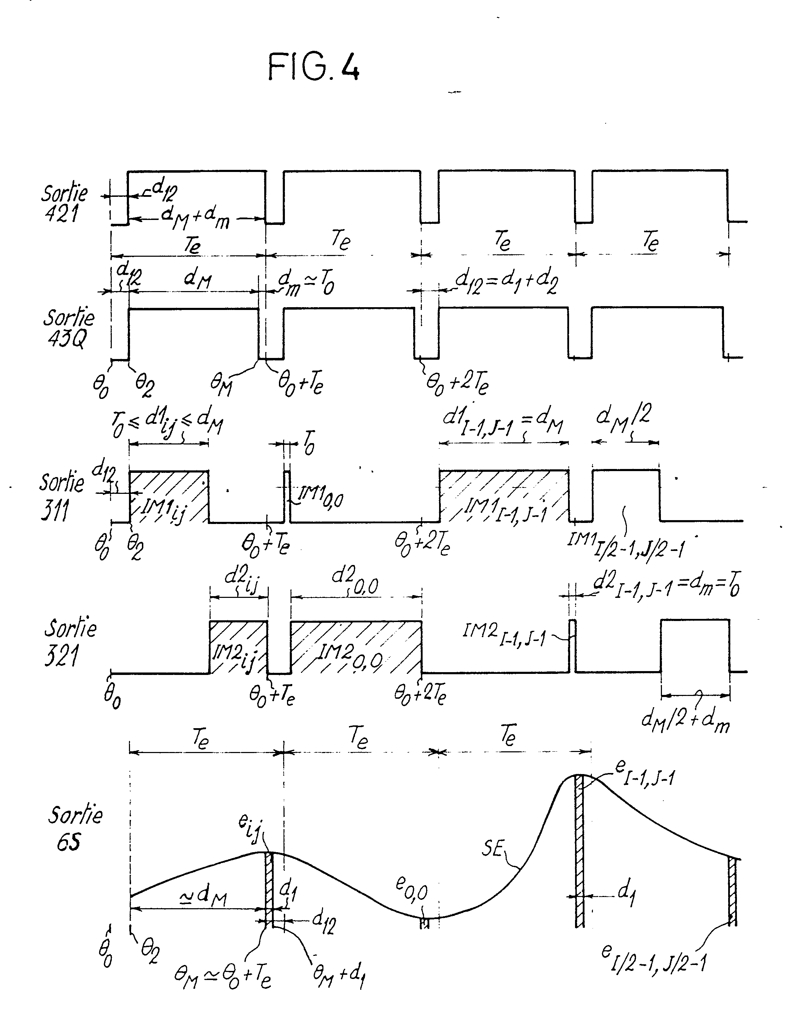

La base de temps 4 est destinée à prélever deux bits tels que $BS_i = $ "1" et $bs_j = $ "1" dans les échantillonneurs ECH et ech pendant une période d'échantillonnage $T_e$ et à commander la conversion d'une impulsion ayant une largeur égale à une période d'horloge $T_0$ sortant du circuit 2 en une impulsion $IM1_{ij}$ ayant une durée $d1_{ij}$ qui est inférieure à une durée maximale $d_M$ elle-même inférieure à $T_e$ et qui dépend de la position temporelle de l'impulsion sortant du circuit 2 dans une période $T_e$, comme montré à une troisième ligne dans la Fig.4. Une période d'échantillonnage $T_e$ débutant à un instant $\theta_0$ est décomposée en trois durées consécutives $d_{12}$, $d_M$ et $d_m$ commençant respectivement à des instants $\theta_0$, $\theta_2$, et $\theta_M$ et finissant respectivement à des instants $\theta_2 = \theta_0 + d_{12}$, $\theta_M = \theta_0 + d_{12} + d_M$ et $\theta_0 + T_e$. L'instant $\theta_2$ détermine le début de transmission d'une impulsion $IM1_{ij}$ par le circuit de modulation 3. L'impulsion $IM1_{ij}$ a une durée $d1_{ij}$ qui est fonction des rangs i et j des bits $BS_i$ et $bs_j$ à l'état "1" dans le mot de quantification prélevé et inférieure ou égale à $d_M$, et donc qui est proportionnelle à la valeur instantanée du signal entrant SE. La durée $d_M$ est celle d'une impulsion $IM1_{I-1,J-1}$ ayant la durée maximale et correspondant à l'amplitude maximale crête-à-crête du signal entrant et donc à un mot de quantification avec des bits $BS_{I-1} = BS_{15} = $ "1" et $bs_{J-1} = bs_{15} = $ "1". Ainsi, sous la commande d'un signal d'horloge $h_0$ de période $T_0$, le compteur COM doit lire les bornes $BS_0$ à $BS_{I-1}$ pendant la durée $d_M$ dans chaque période d'échantillonnage $T_e$, et le compteur com doit lire les bornes $bs_0$ à $bs_{J-1}$ pendant la durée d'analyse de l'une des bornes $BS_0$ à $BS_{I-1}$ à l'état "1". En conséquence, pendant une période d'échantillonnage, le compteur COM effectue un cycle de durée égale à $d_M = I.J.T_0 = 256.T_0 = T_e - d_{12} - d_m$, et le compteur com effectue un cycle de durée égale à $d_M/I = J T_0 = 16 T_0$.

Le compteur 42 et la bascule 43 dans la base de temps 4 élaborent des impulsions de durée $d_M$ positionnées dans les périodes $T_e$ comme montré à une seconde ligne de la Fig.4. A cette fin, une entrée d'horloge 42H du compteur 42 reçoit le signal d'horloge $h_0$ délivré par l'horloge 41. Une sortie 421 du compteur 42 est reliée à une entrée d'horloge 43H de la bascule 43 et passe à "1"

après une durée $d_{12}$ succédant au début $\theta_0$ d'une période d'échantillonnage $T_e$, comme montré à une première ligne de la Fig.4. Une entrée 43D de la bascule 43 étant en permanence à l'état "1", une sortie 43Q de celle-ci produit alors une impulsion de durée $d_M$ à partir de l'instant $\theta_2$ de la période $T_e$, impulsion dont le front descendant est obtenu lorsqu'une sortie 42M du compteur 42 met à "1" une entrée de remise à zéro 43R de la bascule 43, en réponse à un comptage de I.J impulsions d'horloge succédant à l'instant $\theta_2$. Puis après un comptage d'impulsions d'horloge $h_0$ pendant une durée égale à $d_m$, une sortie 42m du compteur 42 reliée à une entrée de remise à zéro 42R de celui-ci passe à "1" afin de remettre à zéro le compteur et les sorties 421, 42M et 42m et d'établir une nouvelle période d'échantillonnage.

A titre d'exemple, la durée $d_{12}$ est égale à $T_e/9$, et la durée $d_m$ est égale à 0, les sorties 42M et 42m étant confondues, ou est par exemple égale à $T_0$, et est considérée dans la suite comme négligeable par rapport aux durées $d_{12}$ et $d_M$, celles-ci étant pratiquement complémentaires dans la période $T_e$. Ainsi le compteur 42 met à "1" la sortie 421 après un comptage de 256/8 = 32 impulsions d'horloge succédant à l'instant $\theta_0$, et met à "1" la sortie 42M après un comptage de 32 + 256 = 288 impulsions d'horloge succédant à l'instant $\theta_0$.

La porte ET 44 a une première entrée 441 recevant les impulsions d'horloge $h_0$ de période $T_0$ et une seconde entrée 442 reliée à la sortie 43Q de la bascule 43 afin de produire en une sortie 443, I.J = 256 impulsions d'horloge pendant la durée $d_M$ de chaque période d'échantillonnage $T_e$. Ces I.J impulsions d'horloge sont appliquées à une entrée du diviseur de fréquence 45 et à une seconde entrée 212 de la porte ET 21.

Le diviseur 45 fournit I = 16 impulsions à une période de $JT_0$ pendant la durée $d_M$ à une entrée d'horloge $EH_0$ du compteur COM qui est activé pour un cycle. Pendant ce cycle de durée $d_M$, le compteur COM ouvre successivement les portes $PE_0$ à $PE_{I-1}$ pour lire les I bornes de sortie $BS_0$ à $BS_{I-1}$ du quantificateur QUA et ainsi détecter l'état "1" de l'une de ces bornes, telle qu'une borne $BS_i$, en réponse à l'impulsion d'horloge de rang i + 1 appliquée à l'entrée $EH_0$ à partir de l'instant $\theta_2$. A travers le compteur COM et la porte OU PO, cette impulsion de rang i + 1 ouvre la porte 21 pendant une durée égale à $JT_0$ succédant à une durée $iJT_0$ à partir de l'instant $\theta_2$ dans la période d'échantillonnage $T_e$ en cours. Un groupe de J impulsions d'horloge consécutives de période $T_0$ est alors appliqué à l'entrée d'horloge $eh_0$ du compteur com par la sortie 213 de la porte 21. Les J impulsions d'horloge sont comptées dans le compteur com qui ouvre successivement les portes $pe_0$

à $pe_{N-1}$ pour balayer les J bornes de sortie $bs_0$ à $bs_{J-1}$ du quantificateur qua et ainsi détecter l'état "1" de l'une de ces bornes, telle qu'une borne $bs_j$, en réponse à l'impulsion d'horloge de rang j + 1 appliquée à l'entrée $eh_0$ pendant la durée $JT_0$. Une sortie 23 de la porte OU po produit une impulsion de largeur $T_0$ après une durée $d1_{ij}-T_0 = iJT_0 + jT_0$ à partir de l'instant $\theta_2$ de la période d'échantillonnage $T_e$ en cours. La durée $d_{12} + d1_{ij} -T_0$ détermine la position temporelle du front montant de l'impulsion d'horloge sortant de la porte po dans une période $T_e$. La durée $d1_{ij} = iJT_0 + (j + 1)T_0$ est égale à la largeur d'une impulsion modulée $IM1_{ij}$ obtenue dans le circuit de modulation 3 et correspondant au codage en durée d'impulsion du mot de quantification prélevé en sortie du circuit 2 et donc du niveau instantané du signal entrant sur une échelle de I.J = 256 niveaux de quantification.

A l'issue de chacun des cycles de balayage respectifs de I = J = 16 bornes, soit à l'expiration d'une durée égale à $IJT_0$, $JT_0$ pendant la durée $d_M$, les compteurs COM et com ont leur compte remis à zéro et demeurent à cet état pendant la durée $d_{12}$ de la période d'échantillonnage suivante, jusqu'à ce que la porte ET 44 soit ouverte. Comme on le verra dans la suite, pendant la durée $d_{12}$, une impulsion modulée est convertie en amplitude et est effacée d'une mémoire, telle que condensateur, dans le démodulateur DEM.

Comme montré également à la Fig.3, le circuit de modulation 3 comprend une bascule bistable 30, un inverseur 300, une porte ET à deux entrées 31, une porte ET à trois entrées 32, un inverseur 33 et un générateur 34 générant, de préférence à partir de la fréquence d'horloge $1/T_0$, deux porteuses de fréquence $fp_1$ et $fp_2$, de préférence très voisines, par des sorties 341 et 342. La bascule 30 a une entrée de mise à "1" 30S reliée à la sortie 421 du compteur 42, ou à l'entrée 442 de la porte 42. Une entrée de remise à "0" 30R de la bascule 30 est reliée à la sortie 23 de la porte OU po à travers l'inverseur 300. Une sortie 30Q de la bascule 30 fournit une impulsion modulée $IM1_{ij}$ ayant une durée $d1_{ij} = iJT_0 + (j + 1)T_0$ lorsque l'état "1" est détecté aux bornes $BS_i$ et $bs_j$ pendant une période d'échantillonnage $T_e$. Le front avant montant d'une telle impulsion $IM1_{ij}$, quels que soient i et j, est toujours positionné à l'instant $\theta_2$ dans une période d'échantillonnage $T_e$, comme montré à une troisième ligne de la Fig.4. Ainsi, au cours d'une période d'échantillonnage et malgré la variation instantanée des indices i et j, le circuit de modulation 3 code le premier niveau de quantification rencontré en une impulsion. La sortie 30Q de la bascule 30 est remise à zéro par le front arrière descendant de l'impulsion d'horloge à la borne 23 et donc aussitôt remise à zéro après l'impulsion

IM1 $_{ij}$ jusqu'à la fin de la période d'échantillonnage. La modulation est donc univoque entre un couple de bits BS$_i$ et bs$_j$ à l'état "1" et une impulsion IM1$_{ij}$.

L'impulsion IM1$_{ij}$ obtenue à la sortie 30Q ouvre la porte 31 ayant des entrées reliées aux bornes 30Q et 341. Une sortie 311 de la porte ET 31 transmet l'impulsion IM1$_{ij}$ modulant la fréquence porteuse fp$_1$ pendant la durée d1$_{ij}$. De préférence pour des raisons concernant un contrôle à la réception dans le démodulateur DEM, une sortie 321 de la porte ET 32 délivre une impulsion IM2$_{ij}$ modulant la fréquence porteuse fp$_2$ et ayant une durée d2$_{ij}$ égale au complément de la durée d1$_{ij}$ pendant la durée d$_M$ de la période d'échantillonnage, ou plus généralement pendant la durée d$_M$ + d$_m$, soit d2$_{ij}$ = d$_M$ + d$_m$ - d1$_{ij}$, l'impulsion IM2$_{ij}$ ayant toujours un front descendant positionné à la fin d'une période T$_e$, comme montré à une quatrième ligne de la Fig.4. A cette fin, les trois entrées de la porte 32 sont respectivement reliées à la sortie 421 du compteur 42 dans la base de temps, à la sortie 30Q de la bascule 30 à travers l'inverseur 33, et à la sortie 342 du générateur 34. Dans ce cas, le moyen de transmission MT convoie dans deux lignes parallèles les impulsions IM1$_{ij}$ et IM2$_{ij}$ multiplexées en fréquence. Comme on le verra dans la suite, la réception des paires d'impulsions successives IM1$_{ij}$ et IM2$_{ij}$ permet de tester la conformité du signal reçu en vérifiant que la somme des durées de deux impulsions "complémentaires" est toujours constante et égale à d$_M$, ou d$_M$ + d$_m$, pendant chaque période d'échantillonnage T$_e$.

Selon une autre variante du modulateur, celui-ci ne comprend qu'un quantificateur QUA et un échantillonneur ECH lorsque le nombre de niveaux de quantification est faible ; dans ce cas, la sortie de la porte OU PO (Fig.3) est reliée directement à l'entrée 30R de la bascule 30 à travers l'inverseur 300.

Le démodulateur DEM est maintenant décrit en référence aux Figs.2, 5 et 6.

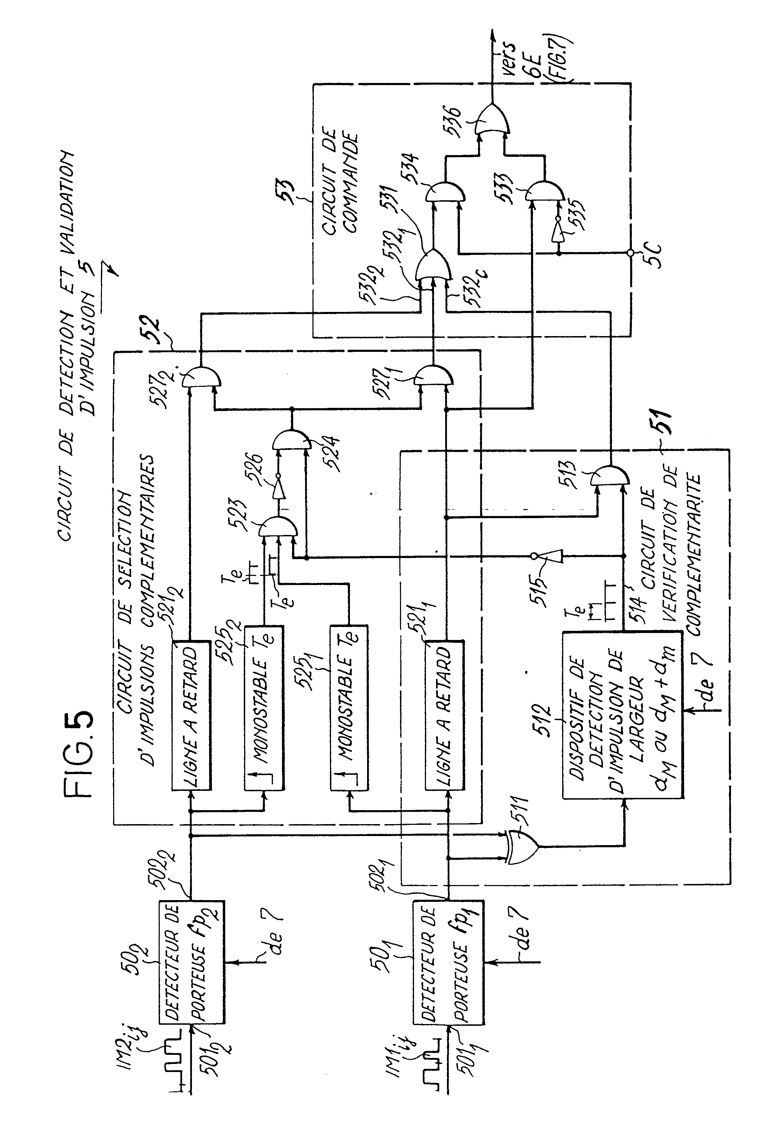

Après amplification dans des moyens d'entrée connus et non représentés du démodulateur, des impulsions IM1$_{ij}$ et IM2$_{ij}$ modulant les fréquences porteuses fp$_1$ et fp$_2$ sont respectivement reçues à des entrées 501$_1$ et 501$_2$ de deux détecteurs de porteuse 50$_1$ et 50$_2$ inclus dans le circuit de détection et validation d'impulsion 5 montré à la Fig.5. Les détecteurs 50$_1$ et 50$_2$ sont de préférence des dispositifs de détection d'impulsions en fonction de leur durée du genre décrit dans la demande de brevet français 85-15418 déposée le 17 Octobre 1985, au nom de l'actuel demandeur. Ces détecteurs 50$_1$ et 50$_2$ sont programmés par la base de temps 7 pour détecter des alternances de sinusoïdes de largeurs 1/(2fp$_1$) et 1/(2fp$_2$) et ainsi restituer des tensions continues en réponse aux porteuses fp$_1$ et fp$_2$ pendant les durées d1$_{ij}$ et d2$_{ij}$ des impulsions IM1$_{ij}$ et IM2$_{ij}$ respectivement. Des sorties 502$_1$ et 502$_2$ restituent ainsi deux impulsions IM1$_{ij}$ et IM2$_{ij}$ sans porteuse, dans chaque période d'échantillonnage T$_e$.

Le circuit 5 comprend également un circuit de vérification de complémentarité 51, un circuit de sélection d'impulsions complémentaires 52 et un circuit de commande 53 en sortie.

Le circuit de vérification de complémentarité 51 comprend une porte OU-Exclusif 511 ayant deux entrées respectivement reliées aux bornes 502$_1$ et 502$_2$, un dispositif de détection d'impulsion 512 relié à la sortie de la porte 511, une porte ET 513 ayant une première entrée reliée directement à la sortie 514 du dispositif 512 et une seconde entrée reliée à la sortie 502$_1$ à travers une ligne à retard 521$_1$, et un inverseur 515 relié à la sortie 514 du dispositif 512. Lorsque pendant une période d'échantillonnage, deux impulsions IM1$_{ij}$ et IM2$_{ij}$ ont des fronts respectifs descendant et montant simultanés et donc sont consécutives, la sortie de la porte 511 transmet une unique impulsion de durée d$_M$, ou d$_M$ + d$_m$, à l'entrée du dispositif 512. Le dispositif 512 est du genre de celui décrit dans la demande de brevet précitée 85-15418, et est programmé par la base de temps 7 pour détecter des impulsions de largeur d$_M$, ou d$_M$ + d$_m$, à la période T$_e$, c'est-à-dire pour détecter des impulsions périodiques de largeur d$_M$, ou d$_M$ + d$_m$, espacées d'un écart temporel égal à d$_{i2}$. La sortie 514 du dispositif 512 est à l'état "1" tant que des impulsions à la sortie de la porte 511 ont des largeurs de d$_M$, ou d$_M$ + d$_m$, et des écarts temporels entre elles de d$_{i2}$, c'est-à-dire tant que des impulsions IM1$_{ij}$ et IM2$_{ij}$ sont rigoureusement complémentaires pendant la durée d$_M$, ou d$_M$ + d$_m$, dans les périodes T$_e$. Dans ce cas, la porte ET 513 est ouverte pour transmettre les impulsions IM1$_{ij}$ appliquées par la ligne à retard 521$_1$ vers une entrée 532$_C$ d'une porte OU à trois entrées 531 incluse dans le circuit de commande 53. Selon une autre variante non illustrée, au lieu de transmettre les impulsions IM1$_{ij}$, les impulsions IM2$_{ij}$ sont transmises par la porte 513 en reliant l'entrée de la ligne à retard 521$_1$ à la sortie 502$_2$ du détecteur 50$_2$, ou en reliant la seconde entrée de la porte 513 uniquement à la sortie 502$_2$ à travers une ligne à retard 521$_2$. La ligne à retard 521$_1$, comme l'autre ligne à retard 521$_2$ dans le circuit de sélection 52, impose un retard égal à d$_M$ ou d$_M$ + d$_m$, ou égal à 2d$_M$ + T$_e$ ou à 2(d$_M$ + d$_m$) + T$_e$ selon le type choisi du dispositif 512 afin de compenser le retard imposé par la détection d'impulsions de durée d$_M$, ou d$_M$ + d$_m$ dans le dispositif 512. Dans la suite, comme déjà dit, on considère que d$_m$ est égal à 0, ou que d$_M$ peut être remplacé par d$_M$ + d$_m$.

Dans le cas où la complémentarité de deux impulsions $IM1_{ij}$ et $IM2_{ij}$ n'est pas reconnue dans le dispositif 512, la porte 513 est fermée et une sortie de l'inverseur 515 active une porte ET à trois entrées 523 et une porte ET à deux entrées 524 incluses dans le circuit de sélection 52. Deux conditions sont alors à distinguer en l'absence de complémentarité d'impulsions.

Selon une première condition, l'absence de complémentarité est due à un allongement ou à un raccourcissement de la durée de l'une des impulsions détectées $IM1_{ij}$ et $IM2_{ij}$. A cause de cette situation indéterminée, le signal reçu est alors éliminé par fermeture de la porte ET 524 grâce à deux bascules monostables $525_1$ et $525_2$ interconnectées respectivement entre les bornes $501_1$ et $501_2$ et deux autres entrées de la porte ET 523 ayant une sortie reliée à une seconde entrée de la porte 524 à travers un inverseur 526. Les bascules monostables ont des constantes de temps égales à $T_e$ et sont redéclenchables par les fronts avant montants des impulsions $IM1_{ij}$ et $IM2_{ij}$ respectivement, de sorte qu'en présence d'impulsions successives et non consécutives $IM1_{ij}$ et $IM2_{ij}$, la porte 523 est ouverte et ferme la porte 524 qui ferme à son tour deux portes ET à deux entrées $527_1$ et $527_2$. Selon la réalisation illustrée à la Fig.5, les portes ET $527_1$ et $527_2$ reçoivent par des secondes entrées les impulsions $IM1_{ij}$ et $IM2_{ij}$ à travers les lignes à retard $521_1$ et $521_2$ et ont des sorties reliées aux deux autres entrées $532_1$ et $532_2$ de la porte OU 531, respectivement. Dans le cas de liaisons télématiques, la sortie de la porte 523 à l'état "1" peut commander l'envoi en arrière, vers la partie de transmission comprenant le modulateur, d'un signal demandant la répétition d'une partie du message, telle que dernier caractère ou octet transmis.

Selon une seconde condition, la complémentarité n'est pas constatée par la porte OU-Exclusif 511 et le dispositif 512, et l'une des impulsions $IM1_{ij}$ et $IM2_{ij}$ n'est pas détectée par les détecteurs $50_1$ et $50_2$. Ceci se traduit par un état "0" à l'une des bornes $502_1$ et $502_2$ pendant au moins une période d'échantillonnage $T_e$, et en pratique, pendant plusieurs périodes $T_e$ lorsque l'un des moyens de transmission des impulsions $IM1_{ij}$ et $IM2_{ij}$ entre le modulateur MOD et le démodulateur DEM est perturbé, par exemple dû au fading sur une porteuse. Dans ce cas, l'une des bascules monostables $525_1$ et $525_2$ n'est pas déclenchée ce qui ferme la porte 523 et ouvre la porte 524 qui commande le passage de l'impulsion détectée $IM1_{ij}$ ou $IM2_{ij}$ à travers la porte ET ouverte respective $527_1$ ou $527_2$. Comme on le verra dans la suite, la démodulation des impulsions $IM1_{ij}$ et celle des impulsions $IM2_{ij}$ conduisent à des signaux en opposition de phase ce qui, dans le cas général et dans la mesure où la perturbation est faible, est sans effet sur une restitution phonique ou numérique du signal démodulé.

Le circuit de commande 53 comprend, outre la porte OU 531, deux portes 533 et 534 ayant respectivement des premières entrées reliées à la borne $502_1$ à travers la ligne à retard $521_1$, et à la sortie de la porte OU 531, des secondes entrées reliées à travers un inverseur 535 et directement à une borne de commande 5C, et des sorties reliées à une borne d'entrée 6E du circuit de démodulation 6 à travers une porte OU à deux entrées 536. Au moyen d'un interrupteur ou de tout autre dispositif de commande, la borne de commande 5C à l'état "1" met en service les circuits 51 et 52 du circuit de détection et de validation 5 en ouvrant la porte 534 et en fermant la porte 533 afin de transmettre à travers la porte OU 531 des premières impulsions $IM1_{ij}$ validées par le dispositif 512 ou des impulsions sélectionnées parmi des impulsions $IM1_{ij}$ et $IM2_{ij}$ détectées par le circuit 52. Dans le cas où aucun contrôle des impulsions n'est désiré, la borne 5C est à l'état "0", la porte 534 est fermée et la porte 533 est ouverte pour transmettre directement des impulsions non contrôlées $IM1_{ij}$ sans porteuse délivrées par la borne $502_1$ à travers la ligne à retard $521_1$.

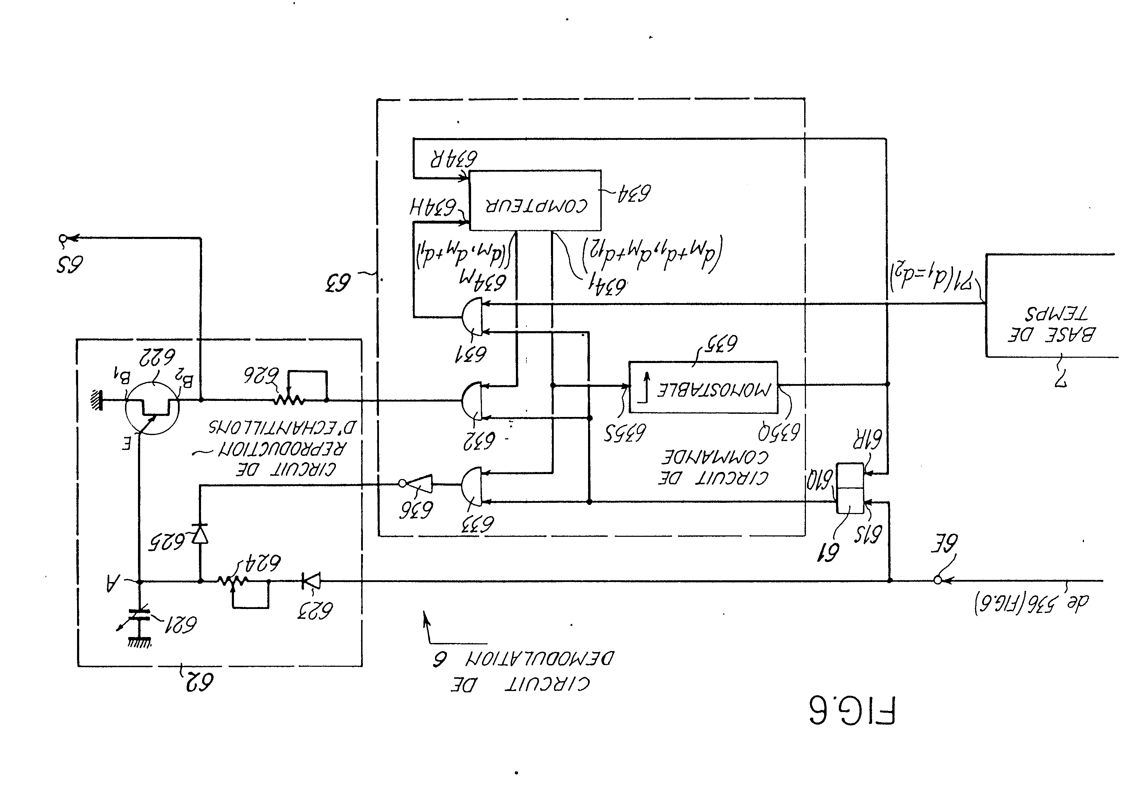

Comme montré à la Fig.6, le circuit de démodulation 6 comprend une bascule bistable 61 pour détecter les fronts montants des impulsions $IM1_{ij}$, auxquelles on se référa dans la suite, ou éventuellement des impulsions $IM2_{ij}$, reçues à l'entrée 6E, un circuit de reproduction d'échantillons du signal entrant 62, et un circuit de commande 63 pour prélever des échantillons.

Le circuit de reproduction d'échantillons 62 comprend essentiellement un condensateur 621 qui, pendant chaque période d'échantillonnage, est chargé par une tension fonction de la largeur d'une impulsion $IM1_{ij}$ reçue pendant cette période, puis est déchargé complètement, et un élément à résistivité variable sous la forme d'un transistor à effet de champ à impédance d'entrée élevée du type transistor unijonction 622 qui est alimenté par la tension mémorisée par le condensateur 621 et donc proportionnelle à la durée $d1_{ij}$ de l'impulsion reçue $IM1_{ij}$ et au niveau de tension quantifiée correspondant du signal entrant SE et établi dans le circuit de quantification 1. Le condensateur 621 a une armature portée à la terre et une autre armature A qui est reliée à l'émetteur E de conductibilité P du transistor 622, à la cathode d'une diode 623 à travers une résistance ajustable 624, et à l'anode d'une diode 625. L'anode de la diode 623 est reliée à la borne d'entrée 6E et à une borne de mise à "1" 61S de la bascule 61. Des bases $B_1$ et $B_2$ du

transistor 622 sont respectivement connectées à la terre et à une borne de sortie 6S du circuit de démodulation reliée à une borne de résistance ajustable 626.

Le circuit de commande 63 comprend trois portes ET à deux entrées 631, 632 et 633, un compteur 634 et une bascule monostable déclenchable par front descendant 635. Des premières entrées des portes 631, 632 et 633 sont reliées à une sortie 61Q de la bascule bistable 61 afin que ces trois portes soient activées en réponse à un front montant d'une impulsion $IM1_{ij}$ détectée à l'entrée 6E par la bascule 61.

Une borne de sortie 71 de la base de temps 7 fournit à une seconde entrée de la porte 631 un signal d'horloge permettant au compteur 634 d'établir la durée $d_M$ et des durées $d_1$ et $d_2$ telles que $d_1 + d_2 = d_{12}$ pendant une période $T_e$. On suppose que, selon l'exemple déjà choisi pour lequel $d_{12} = T_e/9$, les durées $d_1$ et $d_2$ sont égales à $T_e/18$ définissant la période du signal sortant de la borne 71. Un tel signal d'horloge peut être obtenu à partir d'une horloge fournissant un signal d'horloge de période $T_o$ à partir duquel la base de temps 7, établit également, au moyen de diviseurs de fréquence programmables, des fréquences d'horloge nécessaires aux dispositifs de détection d'impulsions $50_1$, $50_2$ et 512 dans le circuit de détection et de validation 5. La base de temps 7 est complètement indépendante de la base de temps 4 dans le modulateur MOD et, par conséquent, les opérations de modulation et démodulation sont asynchrones et ne nécessitent pas un quelconque circuit de récupération d'horloge dans le démodulateur DEM grâce aux dispositifs $50_1$, $50_2$ et 512.

Le compteur 634 comprend ici cinq étages et reçoit à une entrée d'horloge 634H le signal d'horloge de période $d_1$ à travers la porte 631. Une première sortie $634_M$ du compteur 634 est reliée à une seconde entrée de la porte 632 ayant une sortie reliée à travers la résistance 626 à la borne 6S et donc à la base de commande $B_2$ du transistor 622. Une seconde sortie $634_1$ du compteur 634 est reliée d'une part à une seconde entrée de la porte 633 ayant une sortie reliée à la cathode de la diode 625 à travers un inverseur 636, d'autre part à une entrée 635S de la bascule monostable 635 ayant une sortie 635Q reliée à des entrées de remise à zéro 61R et 634R de la bascule 61 et du compteur 634.

En réponse au front avant montant d'une impulsion reçue $IM1_{ij}$ détectée par la bascule 61, marquant le début $\theta_2$ d'une période d'échantillonnage $T_e$ dans le circuit 6, le compteur 634 est activé par des impulsions d'horloge de période $d_1 = d_2$ traversant la porte ouverte 631. Les sorties $634_M$ et $634_1$ demeurent à l'état "0" jusqu'à ce que le compteur 634 ait décompté une durée $d_M$. Pendant cette durée $d_M$, la porte 632 est bloquée et offre une sortie à la terre pour bloquer le transistor unijonction 622 et conserver ainsi une tension nulle à la borne 6S. De même, la porte 633 est bloquée et sa sortie est à "0" ce qui bloque la diode 625 à travers l'inverseur 636 et permet une charge du condensateur 621 à travers la diode 623 et la résistance 624. La résistance 624 est ajustée préalablement afin que la courbe de charge du condensateur 621 pour une durée égale ou inférieure à $d_M$ soit sensiblement une droite. Dans ces conditions, le condensateur 621 est chargé pendant la durée $d1_{ij}$ de l'impulsion $IM1_{ij}$ qui est normalement inférieure ou égale à $d_M$. A l'issue de la durée décomptée $d_M$ correspondant à la plus longue durée des impulsions reçues, la sortie $634_M$ du compteur passe à "1" ce qui ouvre la porte 632 et débloque le transistor 622 pendant une durée $d_1$ succédant à $d_M$, la porte 633 étant encore fermée. Pendant cette durée $d_1$, c'est-à-dire entre des instants $\theta_M$ et $\theta_M + d_1$ d'une période d'échantillonnage $T_e$ comme montré à une cinquième ligne de la Fig.4, la tension de charge du condensateur 621 est appliquée au transistor 622 et détermine la conductivité de celui-ci afin que la borne de sortie 6S du circuit de démodulation délivre un échantillon dont l'amplitude est une fonction linéaire de la durée $d1_{ij}$ de l'impulsion $IM1_{ij}$. Ainsi, à la période $T_e$, la borne 6S recueille des échantillons analogiques $e_{ij}$ de durée $d_1$ ayant des amplitudes proportionnelles aux durées $d1_{ij}$ des impulsions $IM1_{ij}$ et donc aux niveaux de quantification correspondants.

A l'expiration $\theta_2 + d_M + d_1$ de la durée $d_1$, la sortie $634_M$ passe à "0" ce qui ferme la porte 632, bloque le transistor 622 et met la borne 6S au potentiel de 0 volt, et la sortie $634_1$ passe à "1" pendant une durée $d_2$ pour ouvrir la porte 633 et décharger complètement le condensateur 621 à travers la diode passante 625. Après cette période d'effacement $d_2$ de la tension de charge du condensateur 621, un passage de "1" à "0" de la borne $634_1$ est détecté par la bascule monostable 635 qui remet à "0" la bascule 61 et le compteur 634 qui sont de nouveau prêts pour convertir la durée $d1_{ij}$ d'une autre impulsion $IM1_{ij}$ en un échantillon de tension $e_{ij}$ pendant la prochaine période d'échantillonnage.

Les échantillons $e_{ij}$ de durée $d_1$ à la borne 6S sont ensuite amplifiés et lissés dans des moyens connus pour restituer le signal analogique SE entrant initialement dans le modulateur MOD.

D'une manière analogue à une utilisation du circuit de quantification 1 pour convertir plusieurs signaux analogiques, tels que signaux téléphoniques reçus en parallèle en des signaux numériques, décrite dans la demande de brevet français 86-00305, le circuit de quantification 1 peut être utilisé pour convertir N signaux analogiques $SE_1$ à $SE_N$ en des impulsions modulées en durée. Dans ce cas, la base de temps 4 produit des signaux d'adressage vers des circuits de commutation pour sélectionner successivement des échantillons des N signaux analogiques pendant un cycle de durée $NT_e$ qui sont quantifiés dans le circuit 1 et convertis en impulsions modulées en durée par le circuit d'échantillonnage 2 et la bascule 30. La sortie 30Q de la bascule est reliée à N paires de portes ET $31_1$, $32_1$ à $31_N$, $32_N$, telles que les portes 31 et 32, qui sont ouvertes successivement par les signaux d'adressage. Dans ce cas, les paires de porte ET $31_1$, $32_1$ à $31_N$, $32_N$ reçoivent respectivement des paires de porteuses différentes $f_{p11}$, $f_{p21}$ à $f_{p1N}$, $f_{p2N}$. Par exemple, les plus faibles fréquences porteuses sont sensiblement supérieures à la fréquence du signal d'horloge $h_o$. A la réception, N démodulateurs selon l'invention démodulent les impulsions modulant les fréquences porteuses en les signaux $SE_1$ à $SE_N$ respectivement.

Pour cette utilisation, si les compteurs COM et com fonctionnent avec la plus grande fréquence d'horloge des compteurs actuels, soit $1/T_o \cong 25$ MHz, un cycle d'exploration de $I.J = 256$ niveaux de quantification pour l'un des N signaux analogiques a une durée minimale de $256 (10^{-6}/25) = 10,24$ $\mu$s. Cette durée est égale à $d_M = 8T_e/9$ selon l'exemple déjà évoqué, ce qui correspond à une période d'échantillonnage $T_e = 9.10,24/8 = 11,52$ $\mu$s, avec $d_1 = d_2 = T_e/9$. Pour un cycle de sélection à 8 kHz, les signaux analogiques tels que signaux téléphoniques sont en nombre égal à : $N \cong 125/11,52$ soit $N = 10$ voies téléphoniques.

Cette multiple modulation permet par exemple une injection directe dans une ligne téléphonique d'abonné, d'impulsions modulées en durée à travers un équipement de signalisation de ligne d'abonné pour commutateur téléphonique, tel que décrit dans la demande de brevet français FR-A-2 585 526 au nom de l'actuel demandeur ; les signaux injectés sous forme d'impulsions concernent notamment de la signalisation téléphonique, de la parole artificielle et de la modulation téléphonique proprement dite.

Selon une seconde utilisation des modulateur et démodulateur d'impulsions en durée, le signal entrant est un signal numérique, tel qu'un signal MIC à 2048 kbit/s convoyant trente-deux voies. Chacune des voies multiplexées a un octet occupant une fenêtre temporelle de 3,9 $\mu$s dans une trame de 125 $\mu$s. Pour cette seconde utilisation, le circuit de quantification 1 est remplacé par un convertisseur série-parallèle et un circuit de transcodage pour convertir chaque octet de voie dans le signal MIC en un mot de quantification selon l'invention ayant $I + J = 16 + 16 = 32$ bits appliqué au circuit d'échantillonnage à la période de $T_e = 3,9$ $\mu$s. Le circuit de transcodage peut comprendre des mémoires ou des compteurs. Un circuit de récupération classique de signal d'horloge à la fréquence de 2048 kHz et de fréquence trame de 8 kHz permet de commander le circuit de transcodage et de fournir la fréquence $1/T_o$ à la base de temps 4. Lorsque l'octet MIC est transcodé en impulsion codée en durée (256 niveaux), on peut faire bénéficier le système MIC d'un multiplexage temporel asynchrone rendant inutile la voie de verrouillage de trame. Il faut alors 3 dispositifs de modulation en durée pour traiter un ensemble de 30 voies MIC sur la base de compeurs fonctionnant à 25 MHz.

Selon une autre variante, les bits "1" et "0" sont respectivement codés en des impulsions de durées respectives $d1_1$, $d2_1$ et $d1_o$, $d2_o$ telles que $d1_1 > d1_o$ et $d2_1 < d2_o$. En référence aux relations déjà citées de durées $d_{12} = T_e/9$ et $d_M = 8T_e/9$, les durées $d1_1$ et $d1_o$ sont telles que :
$$d1_1, d1_o = < (8/9).(3,9/8) = 0,433 \ \mu s.$$
Par exemple, on peut choisir $d1_1 = 2d1_o$.

## Revendications

1 -Modulateur pour moduler des impulsions en durée en fonction d'un signal de tension entrant - (SE), caractérisé en ce qu'il comprend
des moyens d'entrée (1) pour produire des mots de quantification représentant des valeurs quantifiées d'échantillons du signal entrant, chaque mot de quantification ($BS_o$ à $BS_{I-1}$) comprenant I bits parmi lesquels seulement un bit ($BS_i$) a un état logique prédéterminé ("1") et a un rang (i + 1) dans ledit mot indiquant la valeur quantifiée de l'échantillon parmi I valeurs quantifiées,
des moyens d'échantillonnage (2, 4) pour produire des impulsions modulées en position respectivement en fonction de mots de quantification prélevés à une période d'échantillonnage ($T_e$), une impulsion modulée en position ayant une largeur prédéterminée et ayant une position dans chaque période d'échantillonnage ($T_e$) qui est une fonction linéaire du rang (i + 1) dudit bit ($BS_i$) dans le mot prélevé correspondant ($BS_o$ à $BS_{I-1}$), et
des moyens (3) pour convertir les impulsions modulées en position en des premières impulsions modulées en durée ($IM1_{ij}$).

2 -Modulateur conforme à la revendication 1, caractérisé en ce que les moyens d'échantillonnage (2, 4) comprennent des moyens - (4) pour produire I impulsions d'horloge ($Jh_o$) pendant une première durée ($d_M$) comprise dans une période d'échantillonnage ($T_e$), des moyens de comptage (COM, PE) pour lire successivement les I bits d'un mot de quantification prélevé (BS$_0$ à BS$_{I-1}$) en réponse aux I impulsions d'horloge, et des moyens (PO) pour détecter le bit lu (BS$_i$) ayant ledit état prédéterminé ("1") afin de produire une impulsion d'horloge ayant une position parmi les I impulsions d'horloge égale au rang (i + 1) du bit lu dans le mot prélevé.

3 -Modulateur conforme à la revendication 1, caractérisé en ce que les mots de quantification (BS$_0$ à BS$_{I-1}$, bs$_0$ à bs$_{J-1}$) représentent des valeurs quantifiées d'échantillons selon une loi de quantification à I.J valeurs quantifiées, en ce que chaque mot de quantification est composé d'une première partie (BS$_0$ à BS$_{I-1}$) comprenant I bits parmi lesquels seulement un bit (BS$_i$) a un état logique prédéterminé ("1") et a un rang (i + 1) dans ladite première partie indiquant une première valeur quantifiée de l'échantillon parmi I valeurs quantifiées, et d'une seconde partie (bs$_0$ à bs$_{J-1}$) comprenant J bits parmi lesquels seulement un bit (bs$_j$) a l'état prédéterminé ("1") et a un rang (j + 1) dans ladite seconde partie indiquant une seconde valeur quantifiée de l'échantillon parmi J valeurs quantifiées au voisinage de ladite première valeur quantifiée de l'échantillon, et en ce que les moyens d'échantillonnage (2, 4) produisent une impulsion ayant une position dans chaque période d'échantillonnage (T$_e$) qui est une fonction linéaire du rang (i + 1) dudit bit (BS$_i$) dans la première partie du mot prélevé et du rang (j + 1) dudit bit (bs$_j$) dans la seconde partie du mot prélevé.

4 -Modulateur conforme à la revendication 3, caractérisé en ce que les moyens d'échantillonnage (2, 4) comprennent des moyens (4) pour produire I.J impulsions d'horloge (h$_0$) pendant une première durée (d$_M$) comprise dans une période d'échantillonnage (T$_e$), des premiers moyens de comptage (COM, PE) pour lire successivement les I bits de la première partie (BS$_0$ à BS$_{I-1}$) d'un mot de quantification prélevé en réponse à I groupes de J impulsions d'horloge consécutives, des premiers moyens (P0, 21) pour détecter le bit lu (BS$_i$) dans la première partie du mot prélevé ayant ledit état prédéterminé ("1") afin de transmettre un groupe de J impulsions d'horloge ayant une position parmi les I groupes égale au rang (i + 1) du bit lu de la première partie, des seconds moyens de comptage (com, pe) pour lire successivement les J bits de la seconde partie (bs$_0$ à bs$_{J-1}$) du mot de quantification prélevé en réponse aux J impulsions d'horloge transmis par les premiers moyens pour détecter (P0, 21), et des seconds moyens (po) pour détecter le bit lu (bs$_j$) dans la seconde partie du mot prélevé ayant ledit état prédéterminé ("1") afin de produire une impulsion d'horloge ayant une position parmi les I.J impulsions d'horloge égale à la somme du produit du rang du bit (BS$_i$) dans la première partie (i) moins l'unité par J et du rang (j + 1) dudit bit (bs$_j$) dans la seconde partie.

5 -Modulateur conforme à l'une quelconque des revendications 1 à 4, caractérisé en ce que les moyens pour convertir (3) comprennent des moyens (30, 30S) pour former un front avant d'une première impulsion modulée en durée (IM1$_{ij}$) à la fin d'une seconde durée prédéterminée (d$_{i2}$) succèdant au début ($\theta_0$) d'une période d'échantillonnage (T$_e$), et des moyens (30, 30S) pour former un front arrière de la première impulsion modulée en durée (IM1$_{ij}$) en réponse au front arrière de l'impulsion modulée en position produite pendant la période d'échantillonnage, les premières impulsions modulées en position ayant des largeurs (d1$_{ij}$) inférieures à une première durée (d$_M$) égale ou inférieure au complément de la seconde durée (d$_{i2}$) dans une période d'échantillonnage (T$_e$).

6 -Modulateur conforme à l'une quelconque des revendications 1 à 5, caractérisé en ce qu'il comprend des moyens (31, 34) pour moduler une première fréquence porteuse (fp$_1$) par les premières impulsions modulées en durée (IM1$_{ij}$).

7 -Modulateur conforme à l'une quelconque des revendications 1 à 6, caractérisé en ce que les premières impulsions modulées en position (IM1$_{ij}$) ont des largeurs (d1$_{ij}$) inférieures à une première durée (d$_M$) inférieure à la période d'échantillonnage (T$_e$) et en ce qu'il comprend des moyens (32) pour produire une seconde impulsion modulée en durée (IM2$_{ij}$) ayant une durée (d2$_{ij}$) complémentaire de la durée (d1$_{ij}$) de la première impulsion (IM1$_{ij}$) dans la première durée (d$_M$) de chaque période d'échantillonnage.

8 -Modulateur conforme aux revendications 6 et 7, caractérisé en ce qu'il comprend des moyens (33, 32, 34) pour moduler une seconde fréquence porteuse (f$_{P2}$) par les secondes impulsions modulées en durée (IM2$_{ij}$), les première et seconde fréquences porteuses (f$_{P1}$, f$_{P2}$) étant différentes.

9 -Modulateur conforme à l'une quelconque des revendications 1 à 8, caractérisé en ce que le signal entrant (SE) est un signal analogique et les moyens d'entrée (1) sont un circuit de quantification quantifiant continûment la tension instantanée du signal entrant.

10 -Modulateur conforme à l'une quelconque des revendications 1 à 8, caractérisé en ce que le signal entrant est un signal numérique du type MIC convoyant des mots d'échantillon, tels qu'octets, et les moyens d'entrée (1) sont des moyens de transcodage convertissant chaque mot d'échantillon en un mot de quantification à chaque période d'échantillonnage (T$_e$).

11 -Démodulateur pour démoduler des premières impulsions modulées en durée (IM1$_{ij}$) transmises par le modulateur (MOD) conforme à l'une quelconque des revendications 1 à 10, en des échantillons (e$_{ij}$) du signal entrant, caractérisé en ce qu'il comprend des moyens (61) pour détecter le front avant d'une première impulsion modulée en durée (IM1$_{ij}$), et des moyens (62, 63) pour charger un condensateur (621) par la première impulsion - (IM1$_{ij}$) en réponse au front avant détecté et jusqu'à l'expiration d'une première durée (d$_M$) au moins égale à une largeur maximale des premières impulsions et pour délivrer une tension de charge dudit condensateur (621) pendant une seconde durée (d$_1$) inférieure au complément (d$_{12}$) de la première durée (d$_M$) dans une période d'échantillonnage (T$_e$) afin de produire un échantillon (e$_{ij}$) du signal entrant (SE).

12 -Démodulateur conforme à la revendication 11, caractérisé en ce que les moyens pour charger et délivrer (62, 63) comprennent des moyens de comptage (634) recevant des impulsions d'horloge (d$_1$) asynchrones de quelconques impulsions d'horloge (h$_0$) dans le modulateur (MOD), déclenchés par le front avant détecté de chaque première impulsion modulée en position (IM1$_{ij}$) et remis à zéro après une période d'échantillonnage (T$_e$) succédant à la détection du front avant, pour établir les première et seconde durées (d$_M$, d$_1$).

13 -Démodulateur conforme à la revendication 11 ou 12, caractérisé en ce que les moyens pour charger et délivrer (62, 63) comprennent un élément à résistivité variable, du genre transistor unijonction (622) ayant un émetteur (E) relié à une armature (A) du condensateur (621) et une électrode de commande (B$_2$) délivrant les échantillons (e$_{ij}$), des moyens (633, 636, 625) reliés à ladite armature du condensateur (A) pour charger le condensateur par une première impulsion (IM1$_{ij}$) pendant la première durée (d$_M$) et pour décharger ledit condensateur (621) pendant une durée résiduelle (d$_2$) succédant à la seconde durée (d$_1$) et au plus égale au complément des première et seconde durées (d$_M$, d$_1$) pendant une période d'échantillonnage (T$_e$), et des moyens (632, 626) reliés à ladite électrode de commande (B$_2$) dudit élément (622) pour bloquer l'élément pendant la première durée (d$_M$) et débloquer l'élément pendant la seconde durée (d$_1$).

14 -Démodulateur conforme à l'une quelconque des revendications 11 à 13, caractérisé en ce que les premières impulsions modulées en position (IM1$_{ij}$) transmises par le modulateur (MOD) modulent une première fréquence porteuse (fp$_1$) et en ce que le démodulateur (DEM) comprend des moyens (50$_1$), de préférence programmables, pour détecter des alternances de la première fréquence porteuse (fp$_1$) afin de restituer une tension continue pendant la durée (d1$_{ij}$) d'une première impulsion - (IM1$_{ij}$).

15 -Démodulateur conforme à l'une quelconque des revendications 11 à 14, caractérisé en ce que le démodulateur (DEM) reçoit également des secondes impulsions modulées en durée - (IM2$_{ij}$) transmises par le modulateur (MOD), une seconde impulsion (IM2$_{ij}$) ayant une durée (d2$_{ij}$) complémentaire de la durée (d1$_{ij}$) d'une première impulsion (IM1$_{ij}$) dans la première durée (d$_M$) d'une période d'échantillonnage (T$_e$), et en ce que le démodulateur (DEM) comprend des moyens - (51) pour vérifier la complémentarité des durées - (d1$_{ij}$, d2$_{ij}$) de première et seconde impulsions - (IM1$_{ij}$, IM2$_{ij}$) dans la première durée (d$_M$) afin de délivrer l'une des première et seconde impulsions aux moyens pour détecter le front montant (61) et aux moyens pour charger et délivrer (62, 63) lorsque la complémentarité est vérifiée.

16 -Démodulateur conforme à la revendication 15, caractérisé en ce que les moyens pour vérifier la complémentarité des durées (51) comprennent une porte OU-Exclusif (511) ayant deux entrées - (502$_1$, 502$_2$) recevant respectivement les premières et secondes impulsions (IM1$_{ij}$, IM2$_{ij}$) et des moyens (512), de préférence programmables, reliés à une sortie de la porte OU-Exclusif pour détecter des impulsions ayant ladite première durée (d$_M$) et espacées d'un écart temporel (d$_{12}$) égal au complément de la première durée (d$_M$) dans une période d'échantillonnage (T$_e$).

17 -Démodulateur conforme à la revendication 15 ou 16, caractérisé en ce qu'il comprend des moyens (52) pour inhiber la délivrance de l'une de première et seconde impulsions modulées en position (IM1$_{ij}$ ou IM2$_{ij}$) pendant une période d'échantillonnage (T$_e$) aux moyens pour détecter le front montant (61) et aux moyens pour charger et délivrer (62, 63) lorsque la complémentarité des durées de première et seconde impulsions reçues (IM1$_{ij}$ et IM2$_{ij}$) n'est pas vérifiée.

18 -Démodulateur conforme à l'une quelconque des revendications 15 à 17, caractérisé en ce qu'il comprend des moyens (52) pour délivrer l'une de première et seconde impulsions modulées en position (IM1$_{ij}$, IM2$_{ij}$) pendant une période d'échantillonnage (T$_e$) aux moyens pour détecter le front montant (61) et aux moyens pour charger et délivrer (62, 63) lorsque l'autre des première et seconde impulsions n'est pas reçue ou lorsqu'une fréquence porteuse (fp$_1$, fp$_2$) modulée par l'autre des première et seconde impulsions dans le modulateur (MOD) n'est pas détectée dans le démodulateur (DEM).

FIG.1A

CIRCUIT DE QUANTIFICATION 1

Vers ech (FIG.1B)

Vers ECH (FIG.1B)

FIG.1B

# FIG.2

CIRCUIT DE DETECTION ET DE VALIDATION D'IMPULSION (FIG.5) — 5

DEMODULATEUR DEM

IM2$_{ij}$  501$_2$  502$_2$  502$_2$

DETECTEUR DE PORTEUSE $f_{p_2}$ — 50$_2$

CIRCUIT DE SELECTION — 52

DETECTEUR DE PORTEUSE $f_{p_1}$ — 50$_1$

IM1$_{ij}$  501$_1$  502$_1$

CIRCUIT DE VERIFICATION DE COMPLEMENTARITE — 51

532$_2$  532$_1$  532$_C$

CIRCUIT DE COMMANDE — 53

5C

CIRCUIT DE DEMODULATION (FIG.6) — 6

6E

61S  61  610

61R

635Q'

634R'

CIRCUIT DE COMMANDE — 63

CIRCUIT DE REPRODUCTION D'ECHANTILLONS — 62

6S

BASE DE TEMPS — 7  71

Echantillons SE

MT

0 230 838

FIG.3

0 230 838

— de qua (FIG.1A)

CIRCUIT D'ECHANTILLONNAGE 2

ECH  COM  com  ech

COMPTEUR

EH₀  "0000" "0001"  "1110"  "1111"= I-1

BS₀
BS₁
BS_{i-1}
BS_i
BS_{i+1}
BS_{I-2}
BS_{I-1}
de QUA (FIG.1A)

PE₀  PE₁  PE_{i-1}  PE_i  PE_{i+1}  PE_{I-2}  PE_{I-1}

PO

211  213  21  212

eh₀  COMPTEUR  "0000" "0001"  "1110"  "1111"= J-1

b∆₀
b∆₁
b∆_{j-1}
b∆_j
b∆_{j+1}
b∆_{J-2}
b∆_{J-1}

pe₀  pe₁  pe_{j-1}  pe_j  pe_{j+1}  pe_{J-2}  pe_{J-1}

po

23

4
41  HORLOGE  h₀(T₀)
42H  42R  COMPTEUR 42  42M  42m  421
43D  43  43H  43R  43Q
441  44  442  443
÷ J  45

BASE DE TEMPS

CIRCUIT DE MODULATION 3

300  30Q  32  321  IM2ij  MT
33  31
30  30R  fp₁  fp₂  311  IM1ij
30S  341  342
h₀(T₀)  GENERATEUR DE PORTEUSE  34

# FIG. 4

FIG.5

CIRCUIT DE DETECTION ET VALIDATION
D'IMPULSION 5

CIRCUIT DE SELECTION
D'IMPULSIONS COMPLEMENTAIRES

$IM2_{ij}$

$50_2$ DETECTEUR DE PORTEUSE $fp_2$

$501_2$   $502_2$

de 7

LIGNE A RETARD  $521_2$   $527_2$   52

MONOSTABLE $T_e$  $525_2$   $T_e$  523  526
$T_e$  524

MONOSTABLE $T_e$  $525_1$

53 CIRCUIT DE COMMANDE

$IM1_{ij}$

$50_1$ DETECTEUR DE PORTEUSE $fp_1$

$501_1$   $502_1$

de 7

LIGNE A RETARD  $521_1$

$527_1$

$532_2$  $532_1$  531  534  536
$532_c$

511

512 DISPOSITIF DE DETECTION D'IMPULSION DE LARGEUR $d_M$ ou $d_M+d_m$

$T_e$

515

513

514 CIRCUIT DE VERIFICATION DE COMPLEMENTARITE  51

533  535

vers 6E (FIG.7)

5C

de 7

0 230 838

# FIG.6

CIRCUIT DE DEMODULATION 6

CIRCUIT DE COMMANDE

CIRCUIT DE REPRODUCTION D'ECHANTILLONS

de 536 (FIG.6)

BASE DE TEMPS

MONOSTABLE

COMPTEUR

$71(d_1=d_2)$

$(d_M+d_1, d_M+d_{12})$

$((d_M, d_M+d_1)$

0 230 838